# EUROPEAN PATENT SPECIFICATION

(11) **EP 0 432 848 B1**
(45) Date of publication and mention of the grant of the patent: **12.04.1995**
(21) Application number: 90203234.1
(22) Date of filing: 10.12.1990
(51) Int. Cl.: H01L 21/00, H05K 13/08

(54) **Apparatus for sensing a position of a lead of a component**
Vorrichtung zur Bestimmung der Position eines Bauelementanschlussdrahts
Appareil pour détecter la position de la patte d'un composant

(30) Priority: 13.12.1989 US 450331
(43) Date of publication of application: 19.06.1991
(73) Proprietor: Philips Electronics N.V., 5621 BA Eindhoven (NL)
(72) Inventor: Van De Stadt, Arend, NL-5656 AA Eindhoven (NL)
(74) Representative: Bos, Kornelis Sjoerd

(56) References cited:
- WO-A-88/08512
- US-A- 4 553 843
- IBM TECHNICAL DISCLOSURE BULLETIN. vol. 26, no. 7B, December 1983, NEW YORK US pages 3664 - 3666; V. DI LORENZO: 'COMPONENT POSITION RECOGNITION METHOD AND DEVICE FOR AN ASSEMBLY ROBOT'

## Description

The invention relates to an apparatus for sensing a position of a lead of a component by moving the component relatively to the apparatus along a straight line and with a constant velocity, which apparatus comprises first means for producing a first light beam being adapted to traverse a first path and to be interrupted by the lead, first means for sensing the first light beam, second means for producing a second light beam being adapted to traverse a second path at an angle to said first path and to be interrupted by the lead and second means for sensing the second light beam.

When components with leads are inserted automatically into a printed circuit board, a gripper holds and centers the body of the component. At the moment of insertion, the leads have to be at a correct location with respect to the body of the component. In the event that the lead locations differ too much from those expected locations, the insertion will fail. Automatic insertion requires an accurate measurement of the body to lead tolerance.

An apparatus for measuring the position of the leads of a component with respect to the component is known from US 4.553.843. With this apparatus components are measured which have leads in two parallel rows. The component is moved in a known position through the apparatus. To avoid obstruction of a light beam by more than one lead at the same time, the light beams are at an angle to the plane in which the component is moved. For each row of leads two light beams are necessary. With this apparatus it is not possible to measure the position of leads from components with leads on more than two sides.

The object of the invention is to provide an apparatus with which leads of all kind of components can be measured with a higher accuracy and which has less light beams.

This is achieved in that the apparatus comprises third means for producing a third light beam being adapted to traverse a third path at an angle to said first and said second path and to be interrupted by the lead, third means for sensing the third light beam and means for calculating the average position of the lead based on the respective point of times of interruption of the light beams. The three light beams are situated in the same plane so each lead interupts three times a light beam. In principle the interruption of two light beams which are at an angle to each other is enough to determine the position of the lead. With the information of the interruption of the third light beam it is possible to determine an average position of the lead and to calculate the standard deviation of the average as a measure of accuracy for the lead location measurement. Because there are three light beams it is possible to exclude the information of one light beam for a particular lead if that light beam is interrupted at nearly the same time by another lead. If the lead location measurements are still unreliable, a different position of the component with respect to the apparatus has to be selected by the user.

An embodiment of the apparatus according to the invention is characterized in that the apparatus comprises a gripper for carrying and moving the component relatively to the apparatus, fourth means for producing a fourth light beam being adapted to traverse a fourth path and to be interrupted by the gripper, fourth means for sensing the fourth light beam, fifth means for producing a fifth light beam being adapted to traverse a fifth path and to be interrupted by the gripper, fifth means for sensing the fifth light beam and means for calculating the position of the gripper based on the interruptions of the fourth and fifth light beams and calculating the position of the lead with respect to the gripper.

When determining the positions of the leads of the component in order to place the leads of the component in holes of the printed circuit board it is necessary to know also the exact position of the gripper at the moment of measuring the positions of the leads. This information can be received from a control device of the gripper. In this embodiment according to the invention this information is not necessary any more because the relative position from the leads to the gripper is calculated. Only for positioning the component on a printed circuit board the information from the control device is needed. In this way the accuracy of measuring the position of the leads is further improved.

The invention will now be described by way of an example with reference to the following drawings.

Figure 1A shows a plan view of a beam layout in one embodiment of the invention.

Figure 1B shows an elevation view of the beam layout of figure 1A, taken along the plane through the y-axis.

Figure 2 shows an automated assembly system with an apparatus according to the invention.

Figure 3 shows a flowchart of the software used by the apparatus.

Figure 4 shows a plan view of a second beam layout according to the invention.

Figure 5 shows a third beam layout according to the invention.

Figure 6 shows a fourth beam layout according to the invention.

Figure 7A shows a top view of measurement of a lead location using a dual cell diode.

Figure 7B shows signals resulting from the locations of figure 7A.

Figure 7C shows a front view of the dual cell diode.

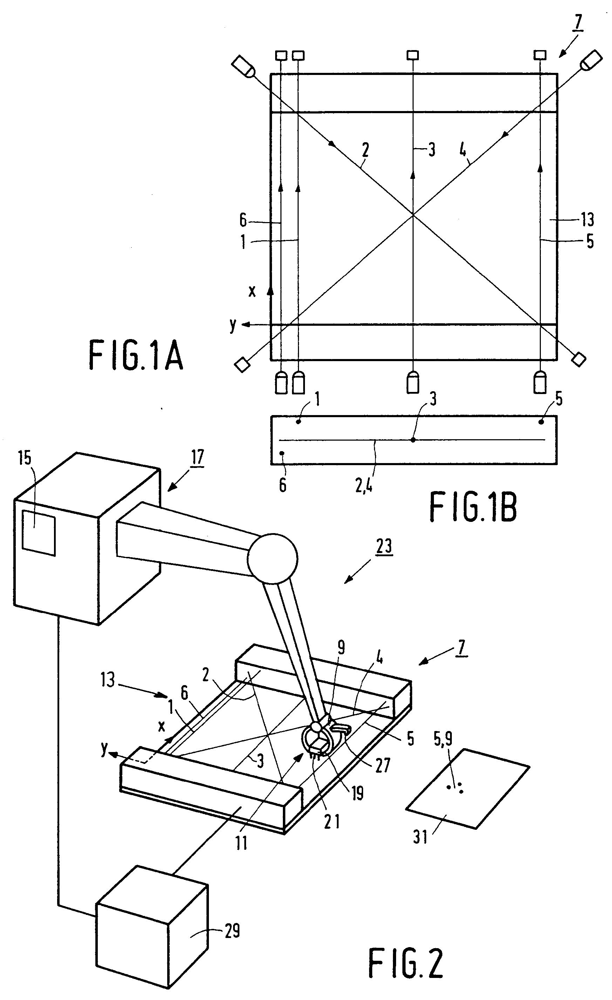

Figures 1A and 1B illustrate a beam layout in one embodiment of an apparatus 7 according to the invention. In figure 1A and 1B, beams 2, 3 and 4 are used to measure the lead location as will be explained later. Beams 1 and 5 are used to measure the velocity of a gripper 9 holding a component 11 during motion through a feedthrough area 13 (see figure 2). Beams 1 and 5 therefore help to eliminate the need to get data from a control device 15 of a gripper 9 of a robot 17 which carries the component 11. The component 11 comprises a body 19 and leads 21 connected to the body 19. Beam 6 is used to determine if any of the leads of the component 11 are too long. Beam 6 triggers an alarm function. Each beam arrangement comprises a matched infrared LED-photodiode-thresholds amplifier pair with focussing lenses, such as the KEYENCE FU 36. These lenses create a very narrow beam more cheaply than would be possible using a laser. An alternative way of creating a narrow beam is to use a very narrow receiving area at the photodiode. The receiving area should be no wider than the leads of the component. With the apparatus 7 lead measurement accuracy has been measured to be 0.1 mm. The maximum velocity of the gripper 9 can be 400 mm/s.

Figure 1A shows two axes X and Y which form the basis for a Cartesian coordinate system defined by the geometry of the apparatus. The axes X and Y do not have a physical existence, but merely serve as a reference frame for calculations. Each beam can be characterized by an equation of the form:${\text{y = a}}_{\text{i}} {\text{x + b}}_{\text{i}} \text{,}$
where i is an integer indicating the beam number. In other words, each beam is defined by a pair of parameters (aᵢ, bᵢ). Figure 2 shows an assembly unit 23 using the apparatus 7 according to the invention. The assembly unit 23 includes the robot 17 with a robot arm 25 and te gripper 9 in which the component 11 is held. The gripper 9 holds the body 19 of the component 11 in a predetermined position. A tool 27 is formed by a lead mounted on the robot gripper 9 used to trigger all measurements and to measure velocity of the gripper 9 during motion through the feedthrough area 13. The robot control device 15 causes the robot arm 25 to move the component 11 through the feedthrough area 13 along a straight line with a known direction and a constant velocity. The line is parallel to the y-axis. A computer 29 calculates the body to lead tolerances of the component 11 as the component 11 passes through the feedthrough area 13. In the event that the body to lead tolerance is acceptable the computer 29 sends data to the robot control device 15, which causes the robot 17 to place the component 11 in the printed circuit board 31.

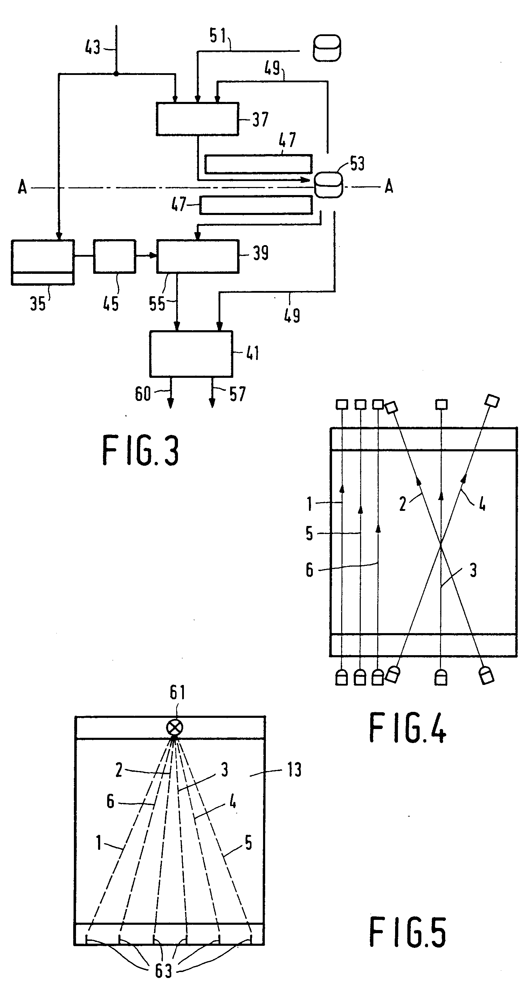

Figure 3 shows a flowchart of the software in the computer 29. The software comprises four main modules: a Data Acquisition Module 35, a Measurement Simulation Module 37, a Lead Location Measurement Module 39 and a Component Location Measurement Module 41. The Data Acquisition Module 35 acquires measurement data and organizes it in a format that is convenient for the Lead Location Measurement Module 39. First, the user provides parameters 43 including, for instance, expected gripper velocity and expected lead offsets. The module 39 then enters a wait state until the tool 27 interrupts the first beam 1 and the measurement is triggered. During data acquisition, the software continuously polls the output of the light beam photodiode amplifiers. The output for each beam is binary: a beam is either OPEN or CLOSED. The six beam amplifier outputs are represented as a six-bit data word. The current value of that data word describes completely the current state of all the beams. The polling routine checks the data word to see if it changed state since the last time it was checked. If it did, the data word and an associated time stamp are stored in two respective arrays: a data array and a time stamp array. The polling routine is the only software that has to run "real-time". Real-time in this context means that the polling loop has to run an order of magnitude faster than the response time of the photodiodes and the amplifiers. The part of the software that runs "real-time" is the part in figure 3 below the line A-A.

The software acquires data for a specified period. Over the entire measurement, each lead should interrupt each beam at most one time. Each interrruption wil cause a particular beam to change state two times from OPEN to CLOSED and from CLOSED to OPEN. The associated times are referred to herein as "tclose" and "topen", respectively. The data words stored in the data array are analyzed to determine which beam caused the interruption. The associated "tclose" and "topen" are used to calculate an estimate for the moment of interruption using the equation:$\text{tavg = (tclose + topen)/2}$
and for the diameter of the lead using the equation:$\text{tdiff = topen - tclose}$
The times tavg and tdiff are stored in a beam timing matrix 45. Each row in the matrix contains a sequence of tavg's and tdiff's of interruptions of one beam. The tavg's are given in increasing value. The tdiff's are also stored in the matrix, to be used in calculation of lead thickness. The beam timing matrix 45 does not contain any information about which lead caused a specific interruption.

The software also measures the actual velocity of the gripper 9 when it moved through the feedthrough area 13. The velocity is calculated by using the time data from beam 1 and 5 interruptions caused by the tool 27. The orthogonal distance between the two parallel beams divided by the difference in interruption times is used as an estimate for the gripper velocity "man-velocity".

The primary function of the Measurement Simulation Module 37 is to provide a correspondence matrix 47. This matrix 47 is required to interpret the beam timing matrix 45. The correspondence matrix 47 gives, for each tavg entry in the beam timing matrix 45, the lead number "leadnb" that caused that interruption. The correspondence matrix 47 is derived with a simulation based on the expected lead layout information 49, the beam layout information 51, and the parameters 43. The expected moment "texp" of each beam interruption by a lead is determined from parameters 43, expected lead layout information 49 and the beam layout information 51 by calculating the travelling distance from the location at triggering until the interruption with the beam and dividing this distance by the expected gripper velocity.

For each beam, the texp's are ranked in a sequence with increasing values. The sequence of corresponding leadnb's is stored as a row in the correspondence matrix 47.

The correspondence matrix 47 can be calculated off-line and stored as part of the component data base 53. The Measurement Simulation Module 37 can be an interactive evaluation tool for lead layouts.

It is not possible to measure all leads in some types of more complex components. The main reason for this is the shadowing effect: a particular lead cannot be detected by interruption of the light beam because another lead is obstructing the view. The user has to evaluate expected lead-beam interruption times and check, for each beam, the time differences between consecutive leads. If this difference is small, changes are that one lead will obstruct the view of the other and that the lead location measurements for both leads will be unreliable. A different angle of the component 11 with respect to the feedthrough area 13 has to be selected by the user. Another possibily is to exclude for a specific lead the point of time of interruption of one beam and to calculate the lead location from the information of the point of times of interruption of the other two beams. If information from more than one beam is unreliable than the lead location cannot be measured.

Individual lead locations are calculated in the Lead Location Measurement Module 39. The module 39 uses in principle the three beams 2, 3 and 4 to derive the lead locations (x_{lead}, y_{lead}). For each lead three equations with two unknowns are constructed in the form:${\text{y}}_{\text{lead}} {\text{= a}}_{\text{i}} {\text{* x}}_{\text{lead}} {\text{+ b}}_{\text{i}} \text{+ tavg * man-velocity}$
where i = 2,3,4 and aᵢ and bᵢ are the beam parameters. Equations (1) are constructed from the beam timing matrix 45 and the correspondence matrices 47. For deriving the lead locations (x_{lead}, y_{lead}) two equations would be sufficient. The lead location is therefore estimated by calculating the average of the three solutions of the three possible combinations of equations. The standard deviation of the average is also calculated and is used as a measure of accuracy for the lead location measurement.

The Component Location Measurement Module 41 calculates the overall component location and verifies the component lead regularity. The measurement is based on a point pattern matching technique described by S. Lee et al. in " A fast computational method for minimum square error transform", Proc. 9th Int'l Conf. Pattern Recognition, (Rome, Italy, 11/88) pp. 392-394. In this paper, a computationally efficient method is described for the matching of two 2-D point patterns (with already established correspondence). The proposed algorithm is implemented and calculates rapidly the translation and rotation which, applied to one pattern, minimizes the sum of the squared distances between corresponding points in the two patterns.

One pattern, for the present software, is the expected lead layout coming from the component database 53. The other pattern is the measured layout 55 from the Lead Location Measurement Module 39. The translation and rotation parameters are calculated relative to the expected lead layout. In this way , the control device 15 can apply the calculated translation and rotation, called "deviation from expected component" 57 directly to the component target location 59 on the printed circuit board 31.

In physical terms, a minimal cumulative squared distance between component leads and holes in the printed circuit board does not guarantee that insertion is possible. A component can not be inserted succesfully if one lead is bent too much, even though all other leads are perfect. If all leads are bent only a small amount, the component can be inserted although the cumulative squared distance might be the same or even bigger as in the one-bent-lead-case. The Component Location Measurement Module 41 therefore also calculates another measure called residual error for each lead: the distance between the transformed (i.e. translated and rotated) expected lead location and the measured lead location. This error is a measure for the local distortion of the lead pattern. The lead can not be inserted if the residual error of that lead is above a certain threshold. If desired, the user can specify different residual errors for different leads (for example when not all the holes have the same dimensions). In the current implementation, the maximum of all residual errors of a component is compared with a user selectable threshold to make a go/no-go component decision 60. the residual error is calculated as described in the above described paper of Lee et al. according to the following equations${\text{r}}_{\text{j}} {\text{= SQRT ((x}}_{\text{l-a,j}} {\text{- x}}_{\text{exp,j}} {\text{)² + (y}}_{\text{l-a,j}} {\text{- y}}_{\text{exp,j}} \text{)²)}$${\text{c = SUM r}}_{\text{j}}$
where c is the cumulative residual error, rⱼ is the residual error of the lead j, x_{l-a,j} is the average of x_{lead} for lead j, x_{exp,j} is the expected x-position of lead j, y_{l-a,j} is the average of y_{lead} for lead j, y_{exp,j} is the y-expected position of lead j, SQRT is the square root function and SUM is the sum function.

Figure 4 shows a second alternate beam layout according to the invention.

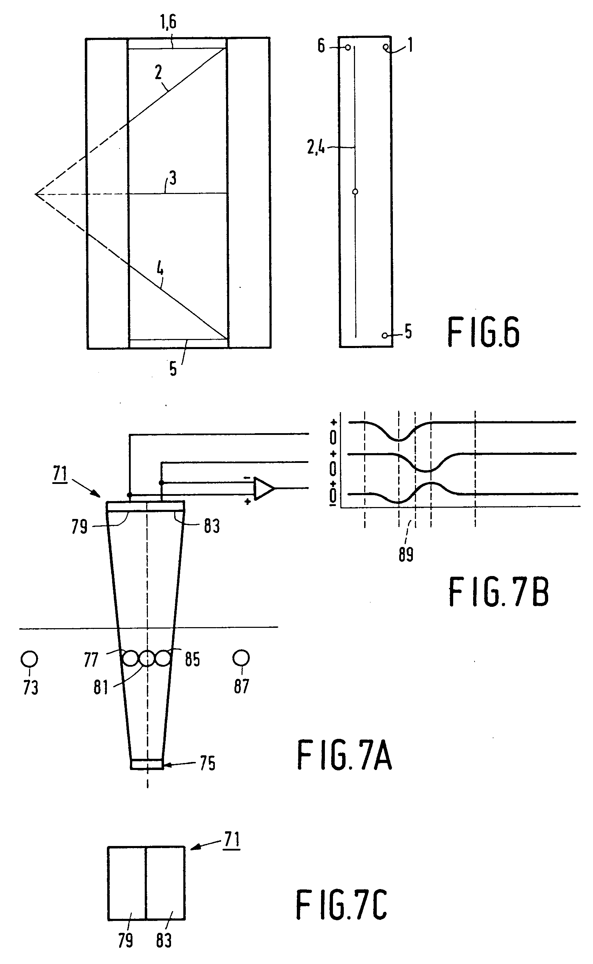

Figure 5 shows a third alternate embodiment in which there is a light source 61 which is multidirectional, and a plurality of sensors 63. Alternatively one can use a single light source with a line scan camera.

Figure 6 shows a fourth embodiment with another beam layout. In figure 4, 5 and 6 the same reference signs for the beams are used as in figure 1 and 2.

As shown in figure 7, for additional accuracy a dual or quad cell photodiode may be used for detecting light beams. Such photodiodes detect gradual interruption of a light beam as a lead passes in front. In conjunction with such photodiodes, a differential amplifier should be used rather than a threshold amplifier.

Figure 7a shows a top view of measurement of a lead location using a dual cell diode 71. At position 73 the lead does not interrupt the light beam from LED 75 at all. At position 77, the lead interrupts the portion of the light beam in front of a first cell 79 of the dual cell diode 71. At position 81, the lead interrupts the portions of the light beam which are in front of both cells 79 and 83. At position 85, the lead interrupts the portion of the light beam which is only in front of the second cell 83. At position 87, the lead again does not interrupt the light beam at all. Figure 7c is a front view of the two cell photodiode 71. These interruptions of the light beams result in the amplified signals from the photodiode 71 shown in figure 7b. The zero crossing signals 89 give accurate measurements of lead locations.

## Claims

1. Apparatus for sensing a position of a lead of a component by moving the component relatively to the apparatus along a straight line and with a constant velocity, which apparatus comprises first means for producing a first light beam being adapted to traverse a first path and to be interrupted by the lead, first means for sensing the first light beam, second means for producing a second light beam being adapted to traverse a second path at an angle to said first path and to be interrupted by the lead and second means for sensing the second light beam, characterized in that the apparatus comprises third means for producing a third light beam being adapted to traverse a third path at an angle to said first and said second path and to be interrupted by the lead, third means for sensing the third light beam and means for calculating the average position of the lead based on the respective point of times of interruption of the light beams.

2. Apparatus as claimed in claim 1, characterized in that the apparatus comprises a gripper for carrying and moving the component relatively to the apparatus, fourth means for producing a fourth light beam being adapted to traverse a fourth path and to be interrupted by the gripper, fourth means for sensing the fourth light beam, fifth means for producing a fifth light beam being adapted to traverse a fifth path and to be interrupted by the gripper, fifth means for sensing the fifth light beam and means for calculating the position of the gripper based on the respective point of times of interruption of the fourth and fifth light beams and calculating the position of the lead with respect to the gripper.

## Patentansprüche

1. Vorrichtung zum Abtasten der Lage eines Bauelementanschlußdrahts durch Bewegung des Bauelements relativ zu der Vorrichtung entlang einer geraden Linie und mit einer konstanten Geschwindigkeit, wobei die Vorrichtung ein erstes Mittel zur Erzeugung eines zur Durchquerung eines ersten Weges und zur Unterbrechung durch den Anschlußdraht eingestellten ersten Lichtbündels, ein erstes Mittel zur Erfassung des ersten Lichtbündels, ein zweites Mittel zur Erzeugung eines zur Durchquerung eines unter einem Winkel zu obigem ersten Weg verlaufenden zweiten Weges und zur Unterbrechung durch den Anschlußdraht eingestellten zweiten Lichtbündels sowie ein zweites Mittel zur Erfassung des zweiten Lichtbündels enthält, dadurch gekennzeichnet, daß die Vorrichtung mit einem dritten Mittel zur Erzeugung eines zur Durchquerung eines unter einem Winkel zu obigem ersten und obigem zweiten Weg verlaufenden dritten Weges und zur Unterbrechung durch den Anschlußdraht eingestellten dritten Lichtbündels, einem dritten Mittel zur Erfassung des dritten Lichtbündels und mit Mitteln zur Berechnung der durchschnittlichen Lage des Anschlußdrahts anhand der jeweiligen Unterbrechungszeitpunkte der Lichtbündel versehen ist.

2. Vorrichtung nach Anspruch 1, dadurch gekennzeichnet, daß die Vorrichtung mit einem Greifer zum Tragen und Bewegen des Bauelements relativ zur Vorrichtung, einem vierten Mittel zur Erzeugung eines zur Durchquerung eines vierten Weges und zur Unterbrechung durch den Greifer eingestellten vierten Lichtbündels, einem vierten Mittel zur Erfassung des vierten Lichtbündels, einem fünften Mittel zur Erzeugung eines zur Durchquerung eines fünften Weges und zur Unterbrechung durch den Greifer eingestellten fünften Lichtbündels, einem fünften Mittel zur Erfassung des fünften Lichtbündels sowie Mitteln zur Berechnung der Lage des Greifers aufgrund der Unterbrechungszeitpunkte jeweils des vierten und fünften Lichtbündels und zur Berechnung der Lage des Anschlußdrahts zum Greifer versehen ist.

## Revendications

1. Appareil pour détecter la position de la patte d'un composant en déplaçant le composant relativement à l'appareil suivant une ligne droite et à vitesse constante, lequel appareil comporte un premier moyen pour produire un premier rayon lumineux conçu pour parcourir un premier chemin et être interrompu par la patte, un premier moyen pour détecter le premier rayon lumineux, un second moyen pour produire un second rayon lumineux conçu pour parcourir un second chemin oblique par rapport audit premier chemin et être interrompu par la patte et un second moyen pour détecter le second rayon lumineux, caractérisé en ce que l'appareil comprend un troisième rayon lumineux conçu pour parcourir un troisième chemin oblique par rapport auxdits premier et second chemins et être interrompu par la patte, un troisième moyen pour détecter le troisième rayon lumineux et un moyen pour calculer la position moyenne de la patte sur base des moments respectifs de l'interruption des rayons lumineux.

2. Appareil suivant la revendication 1, caractérisé en ce que l'appareil comprend une pince pour transporter et déplacer le composant relativement à l'appareil, un quatrième moyen pour produire un quatrième rayon lumineux conçu pour parcourir un quatrième chemin et être interrompu par la pince, un quatrième moyen pour détecter le quatrième rayon lumineux, un cinquième moyen pour produire un cinquième rayon lumineux conçu pour parcourir un cinquième chemin et être interrompu par la pince, un cinquième moyen pour détecter le cinquième rayon lumineux et un moyen pour calculer la position de la pince sur base des moments d'interruption des quatrième et cinquième rayons lumineux et calculer la position de la patte par rapport à la pince.
